# EUROPÄISCHE PATENTSCHRIFT

(11) **EP 3 250 724 B1**
(45) Veröffentlichungstag und Bekanntmachung des Hinweises auf die Patenterteilung: **09.01.2019**
(21) Anmeldenummer: 15801351.6
(22) Anmeldetag: 10.11.2015
(51) Int. Cl.: C23C 2/00, C23C 2/02, C23C 2/06, C23C 2/26, C23C 2/40, C21D 1/00

(54) **VERFAHREN ZUM AUFBRINGEN EINES METALLISCHEN SCHUTZÜBERZUGS AUF EINE OBERFLÄCHE EINES STAHLPRODUKTS**
METHOD FOR APPLYING A METAL PROTECTIVE COATING TO A SURFACE OF A STEEL PRODUCT
PROCÉDÉ DE DÉPÔT D'UN REVÊTEMENT PROTECTEUR MÉTALLIQUE SUR UNE SURFACE D'UN PRODUIT EN ACIER

(30) Priorität: 29.01.2015 DE 102015101312
(43) Veröffentlichungstag der Anmeldung: 06.12.2017
(73) Patentinhaber: ThyssenKrupp Steel Europe AG, 47166 Duisburg (DE)
(72) Erfinder: NORDEN, Martin, 45276 Essen (DE); KLÜPPEL, Ingo, 44791 Bochum (DE); GIZA, Miroslaw, 45659 Recklinghausen (DE)
(74) Vertreter: thyssenkrupp Intellectual Property GmbH
(86) Internationale Anmeldenummer: PCT/EP2015/076207
(87) Internationale Veröffentlichungsnummer: WO 2016/119936

(56) Entgegenhaltungen:
- DE-A1- 2 609 968
- DE-A1- 19 942 025
- JP-A- S5 310 329
- JP-A- S6 376 861
- US-A- 3 177 085
- US-A- 4 201 592
- R. LÓPEZ IBÁÑEZ ET AL: "Oxide barrier coatings on steel strip by spray pyrolysis", SURFACE AND COATINGS TECHNOLOGY, Bd. 188-189, 1. November 2004 (2004-11-01) , Seiten 675-683, XP055252394, AMSTERDAM, NL ISSN: 0257-8972, DOI: 10.1016/j.surfcoat.2004.07.002
- M M ET AL: "Protecting Steel for Generations", , 1. Januar 2010 (2010-01-01), XP055252475, Gefunden im Internet: URL:https://www.galvanizeit.org/images/upl oads/pdfs/Masking_Materials_for_Preventing _Hot-Dip_Galvanizing,_Bernardo_Duran__Thom as_Langill,_Ph.D_(Galvanizing_Notes,_2010_ Dec)_.pdf [gefunden am 2016-02-23]

## Beschreibung

Die Erfindung betrifft ein Verfahren zum Aufbringen eines metallischen Schutzüberzugs auf eine Oberfläche eines Stahlprodukts, bei dem mindestens eine andere Oberfläche frei von der metallischen Schutzbeschichtung bleiben soll, wobei der Auftrag der metallischen Schutzbeschichtung durch Schmelztauchbeschichten in einem Schmelztauchbad erfolgt und vor dem Schmelztauchbeschichten diejenige Oberfläche, die frei von der metallischen Schutzbeschichtung bleiben soll, mit einer aus SiO₂ bestehenden Vorbeschichtung versehen wird, die beim Schmelztauchbeschichten ein Anhaften der metallischen Schutzbeschichtung an der betreffenden Oberfläche verhindert.

Die Beschichtung mit einem metallischen Schutzüberzug ist eine bewährte Möglichkeit, Stahlprodukte vor Korrosion zu schützen, die aufgrund ihrer Zusammensetzung grundsätzlich korrosionsgefährdet sind. Für viele Verwendungszwecke ist es dabei ausreichend und im Hinblick auf eine ökonomische und ressourcenschonende Herstellung und Verarbeitung wünschenswert, nur diejenigen Flächen oder denjenigen Flächenabschnitt mit dem Schutzüberzug zu versehen, der im praktischen Einsatz dem korrosiven Angriff ausgesetzt ist.

Eine kostengünstige und in der großtechnischen Praxis bewährte Möglichkeit, einen metallischen Schutzüberzug auf ein Stahlprodukt aufzubringen, ist das Schmelztauchbeschichten.

Beim Schmelztauchbeschichten passiert das zu beschichtende Produkt stückweise oder im kontinuierlichen Durchlauf ein Schmelztauchbad, das aus einem schmelzflüssigen, den Schutzüberzug bildenden Metall oder aus einer schmelzflüssigen Metalllegierung gebildet ist. Dem Durchlauf durch das Schmelztauchbad ist üblicherweise eine Wärmebehandlung vorgeschaltet. Deren Zweck besteht darin, das jeweils zu beschichtende Stahlsubstrat so zu konditionieren und seine Oberfläche so zu aktivieren, dass einerseits optimierte Materialeigenschaften erzielt werden und andererseits eine optimale Benetzung und Haftung des Überzugs auf dem Stahlsubstrat gewährleistet ist.

Besonders bewährt haben sich Schutzüberzüge auf Basis von Zink oder Aluminium, die neben ihren Hauptbestandteilen jeweils weitere Legierungselemente enthalten können, um die jeweils gewünschten Eigenschaften des Überzugs einzustellen.

Gerade Stahlflachprodukte, bei denen es sich typischerweise um aus einem Stahlsubstrat gebildete Walzprodukte, wie Stahlbleche oder -bänder, daraus gewonnene Zuschnitte oder Platinen und desgleichen, handelt, lassen sich im großtechnischen Rahmen durch im kontinuierlichen Durchlauf absolvierte Schmelztauchbeschichtungsverfahren wirtschaftlich mit einem vor Korrosion schützenden metallischen Überzug versehen. Aus Stahlflachprodukten geformte oder zusammengesetzte Stahlbauteile, die nach ihrer Herstellung mit einem Schutzüberzug versehen werden sollen, werden dagegen in der Regel durch stückweises Eintauchen in das jeweilige Schmelzenbad schmelztauchbeschichtet. In Fällen, in denen zwar das Schmelztauchbeschichten angewendet, jedoch nur eine bestimmte Fläche des Stahlprodukts mit dem Schutzüberzug versehen werden soll, muss allerdings jeweils die Fläche, die von dem Überzug freigehalten werden soll, so vorbereitet werden, dass das Metall des Überzugs beim Eintauchen in das Schmelzenbad dort nicht anhaftet.

In der DE 26 09 968 A1 ist hierzu vorgeschlagen worden, vor dem Schmelztauchbeschichten eines Stahlflachprodukts mit einem Zn-Schutzüberzug ein Silikonharz auf die Seite des Stahlflachprodukts aufzutragen, die nicht mit Zink beschichtet werden soll. Nach dem Auftrag des Silikonharzes wird das Stahlflachprodukt in einer oxidierenden Atmosphäre auf 300 - 800 °C gebracht, um die Silikonharzschicht in das Stahlsubstrat einzubrennen. Ziel dieses Einbrennvorgangs ist die Bildung einer deckenden SiO₂-Schicht auf der nicht zu beschichtenden Fläche. Anschließend wird das derart vorbeschichtete Stahlflachprodukt einer Wärmebehandlung unter einer reduzierenden Atmosphäre unterzogen und schließlich in ein Zinkschmelzenbad eingeführt, wo die nicht vorbeschichteten Bereiche der Oberfläche verzinkt werden. Die erfolgreiche einseitige Verzinkung soll hier wesentlich davon abhängen, dass beim Glühen unter der reduzierenden Atmosphäre die nicht zu beschichtende Fläche des Stahlflachprodukts mit einem ausreichend dicken SiO₂-Film belegt ist, der verhindert, dass die nicht zu beschichtende Fläche aktiviert wird, und der gleichzeitig eine Barriere für einen Kontakt der nicht zu beschichtenden Fläche mit dem schmelzflüssigen Überzugsmetall bildet. Um eine ausreichende Dicke des SiO₂-Films zu gewährleisten, liegt das Auflagengewicht, mit dem das Silikonharz auf das Stahlsubstrat aufgebracht wird, im Bereich von 0,5 - 50 g/m², wobei bei der praktischen Erprobung des bekannten Verfahrens Auflagengewichte von 0,7 - 47 g/m² vorgesehen waren.

Ein ähnliches Verfahren ist aus US3177085 bekannt.

Da trotz dieser Vorkehrungen bei dem bekannten Verfahren in der Praxis nicht verhindert werden kann, dass es zur Benetzung der nicht zu beschichtenden Fläche des Stahlflachprodukts mit schmelzflüssigem Überzugsmetall kommt, sieht das bekannte Verfahren zusätzlich vor, die mit dem Silikonharz beschichtete Oberfläche des Stahlbands nach dem Verlassen des Zinkbades abzubürsten, um einerseits möglicherweise vorhandene Anlagerungen des Überzugsmaterials und andererseits die Silikonharzbeschichtung selbst zu entfernen.
Vor dem Hintergrund des voranstehend erläuterten Standes der Technik ergab sich die Aufgabe, ein Verfahren zu entwickeln, welches es erlaubt, bei minimiertem Aufwand und optimierter Ressourcenschonung mindestens eine bestimmte Fläche eines Stahlprodukts durch Schmelztauchbeschichten mit einem metallischen Schutzüberzug zu versehen, und mindestens eine andere Fläche des Stahlflachprodukts frei von dem Schutzüberzug zu halten.

Diese Aufgabe ist durch das in Anspruch 1 angegebene Verfahren gelöst worden.

Vorteilhafte Ausgestaltungen der Erfindung sind in den abhängigen Ansprüchen angegeben und werden nachfolgend wie der allgemeine Erfindungsgedanke im Einzelnen erläutert.

In Übereinstimmung mit dem eingangs erläuterten Stand der Technik erfolgt auch beim erfindungsgemäßen Verfahren das Aufbringen des metallischen Schutzüberzugs auf eine Oberfläche eines Stahlprodukts, bei dem mindestens eine andere Oberfläche frei von dem metallischen Schutzüberzug bleiben soll, durch Schmelztauchbeschichten in einem Schmelztauchbad und es wird vor dem Schmelztauchbeschichten diejenige Oberfläche, die frei von dem metallischen Schutzüberzug bleiben soll, mit einer aus SiO₂ bestehenden Vorbeschichtung versehen, die beim Schmelztauchbeschichten ein Anhaften des metallischen Schutzüberzugs an der betreffenden Oberfläche verhindert.

Erfindungsgemäß wird nun als Vorbeschichtung eine aus amorphem Siliziumdioxid bestehende Schicht mit einer Schichtdicke von 0,5 - 500 nm aus der Gasphase auf die von dem metallischen Schutzüberzug freizuhaltende Oberfläche des Stahlprodukts abgeschieden.

Die Erfindung stellt somit ein Verfahren zur Herstellung eines einseitig schmelztauchveredelten Stahlflachprodukts zur Verfügung, bei dem kein Silikonharz verwendet werden muss, aus dem über einen gesonderten Einbrenn- und Oxidationsschritt ein vergleichbar dicker SiO₂-Film auf der von dem Schutzüberzug freizuhaltenden Fläche des Stahlprodukts gebildet wird. Stattdessen sieht die Erfindung vor, dass durch Einsatz eines geeigneten Abscheideverfahrens eine dünne SiO₂-Schicht direkt und ohne Zwischenträger auf der vor einem Kontakt mit der Überzugsschmelze beim Schmelztauchbeschichten zu schützenden Fläche des Stahlprodukts abzuscheiden. Zu diesem Zweck können im jeweiligen Abscheideprozess silizium-organische Verbindungen eingesetzt werden, bei denen es sich jedoch um keine Silikonharze handelt, wie sie beim eingangs erläuterten Stand der Technik verwendet werden.

Da die siliziumhaltigen, die Vorbeschichtung bildenden Verbindungen direkt auf das Stahlsubstrat abgeschieden werden, entfällt beim erfindungsgemäßen Verfahren der Prozessschritt des Einbrennens. Darüber hinaus hat die erfindungsgemäß vorgesehene gezielte Abscheidung der SiO₂-Schicht aus der Gasphase gegenüber Beschichtungsarten, bei denen die SiO₂-Schicht aus der Flüssigphase gebildet wird, den Vorteil, dass die Abscheidung aus der Gasphase unabhängig von aufwändigen Prozessbädern ist, einen deutlich geringeren Einsatzstoffumsatz erfordert und minimierte Schichtdicken im Nanometerbereich ermöglicht. Dies alles führt bei Anwendung des erfindungsgemäßen Verfahrens zu einer deutlichen Reduktion der Entstehung von Abfallstoffen und damit einhergehend zu einer ebenso deutlich gegenüber den bekannten Verfahren verminderten Belastung der Umwelt.

Das Vorbeschichten der vom metallischen Schutzüberzug freizuhaltenden Fläche des Stahlprodukts kann mittels bekannter und in der Praxis bewährter Verfahren erfolgen. Abhängig vom jeweiligen Ausgangsprodukt und der Art und Weise, wie die weiteren Verarbeitungsschritte absolviert werden, kann es dabei zweckmäßig sein, die Vorbeschichtung stückweise in einem diskontinuierlichen Verfahrensablauf auf dem Stahlprodukt abzuscheiden oder die Abscheidung in einem kontinuierlichen Verfahrensablauf vorzunehmen. Eine in einem kontinuierlichen Verfahrensablauf erfolgende Abscheidung der Vorbeschichtung auf die jeweils nicht zu beschichtende Fläche bietet sich beispielsweise dann an, wenn es sich bei dem Stahlprodukt um ein Stahlflachprodukt, insbesondere ein Stahlband handelt. Dies gilt insbesondere dann, wenn die Vorbeschichtung in einen Schmelztauchbeschichtungsprozess eingebunden wird, der von der Vorbeschichtung bis zum Durchlauf durch das Schmelztauchbad insgesamt im kontinuierlichen Durchlauf abgewickelt wird.

Die erfindungsgemäß vorgesehene Abscheidung der Vorbeschichtung kann beispielsweise mittels Flammenpyrolyse erfolgen. Durch Flammenpyrolyse erzeugte Schichten dienen in der Regel als Haftvermittler zwischen anorganischen Substraten und organischen Beschichtungen, insbesondere zwischen metallischen Substraten und organischen Beschichtungen. Wird eine erfindungsgemäß beschaffene Vorbeschichtung mittels Flammenpyrolyse auf das jeweilige Stahlsubstrat aufgebracht, so zeigt sich überraschender Weise, dass es trotz der minimierten Schichtdicken zu keiner Benetzung der jeweils vom Schutzüberzug freizuhaltenden Fläche des Stahlsubstrats kommt. Das Flammenpyrolyse-Verfahren ist beispielsweise in der Dissertation von Dr. Bernhard Schinkinger "Schichtanalytische und elektrochemische Untersuchungen zur Abscheidung dünner SiO₂- und Organosilanschichten auf verzinktem Stahl", veröffentlicht unter der URL: "http://www-brs.ub.ruhr-uni-bochum.de/netahtml/HSS/Diss/SchinkingerBernhard/diss.pdf" (siehe auch URL http://www-brs.ub.ruhr-uni-bochum.de/netahtml/HSS/Diss/SchinkingerBernhard/) im Detail erläutert.

Bezogen auf die vorliegende Erfindung kann für die Beschichtung mittels Flammenpyrolyse ein siliziumorganischer Precursor mit einer Durchflussmenge von 10 - 5.000 ml/min und einer Verdampfertemperatur von -50 °C bis +100 °C (z. B. Hexamethyldisiloxan "HMDSO") in einem brennbaren Gas oder Gasgemisch (z. B.
Luft/Propan oder Luft/Butan) flammenpyrolytisch zersetzt werden, das dadurch auf dem durch die Brennerflamme geführten Blech abgeschieden wird. Durch Veränderung des Brennerabstandes, der Beschichtungsgeschwindigkeit, der Gasmischung und Zusammensetzung und der Anordnung der Brenner können die Dicke und Eigenschaften der abgeschiedenen Schicht variiert werden, um die optimalen Eigenschaften einzustellen. Hierzu können beispielsweise der Brennerabstand im Bereich von 0,5 - 10 cm und die Beschichtungsgeschwindigkeit im Bereich von 1 - 300 m/min variiert werden. Als brennbares Gas können Propan oder Butan verwendet werden. Wird unter Verwendung eines dieser brennbaren Gase ein aus Gas und Luft gebildetes brennbares Gasgemisch eingesetzt, so kann der Anteil des brennbaren Gases an dem Gemisch 10 - 100 Vol.-% betragen. D.h., auch die Möglichkeit, mit reinem Gas ohne Beimischung von Luft zu arbeiten, ist hier im Sinne der Erfindung vom Begriff "brennbares Gasgemisch" umfasst. Auch über die Anordnung und Anzahl der für die Flammenpyrolyse eingesetzten Brenner kann das Beschichtungsergebnis positiv beeinflusst werden. So kann es bei einer im Durchlauf erfolgenden Flammenpyrolyse zweckmäßig sein, bis zu 10 Brenner in Durchlaufrichtung des zu beschichtenden Stahlsubstrats in Reihe aufeinander folgende Brenner vorzusehen. Eine Vorbehandlung des Stahlsubstrats ist aufgrund der guten Hafteigenschaften nicht notwendig.

Für die Abscheidung der erfindungsgemäß vorgesehenen Vorbeschichtung können auch bekannte, im Stand der Technik zur Verfügung stehende chemische (CVD) oder physikalische (PVD) Abscheideverfahren eingesetzt werden ("CVD" = Chemical Vapour Deposition; "PVD" = Physical Vapour Deposition).

Bei der praktischen Erprobung bewährt hat sich hier die Deposition der erfindungsgemäß vorgesehenen Vorbeschichtung mittels Hohlkathodenglimmentladung. Durch dieses in der Praxis auch als "PE-CVD" genannte Verfahren können kompakte, siliziumhaltige Schichten, so genannte Plasmapolymer-Schichten ("PP"), hergestellt werden. Beim SHC-Prozess wird für die Beschichtung ein Gemisch aus einem Trägergas (z.B. eine Mischung aus Sauerstoff und Argon) und einem Silizium-organischen Precursor in einem Niederdruck-Plasma zersetzt und auf dem Blech abgeschieden. Eine detaillierte Erläuterung dieses Prozesses findet sich in der Dissertation von Dr. Krasimir Nikolov "Untersuchungen zur plasmagestützten Abscheidung von Schichten auf Stahlfeinblech im Niederdruck bei hohen Raten", Shaker Verlag GmbH, März 2008, ISBN 978-3-8322-7068-1. Ein Vorteil dieser Vorgehensweise liegt in dem deutlich geringeren Gasverbrauch aufgrund des abgesenkten Arbeitsdruckes. Dabei ist es möglich, durch Veränderung der Beschichtungsparameter, wie eingekoppelte elektrische Leistung, Gaszusammensetzung, Gasflussgeschwindigkeit, die Dicke und die Eigenschaften der abgeschiedenen Schicht zu optimieren. Bei einer in der Praxis eingesetzten Beschichtungsanlage beträgt die eingekoppelte elektrische Leistung 0,3 kW. Als Trägergas werden 40 sccm Argon in 400 sccm Sauerstoff miteinander gemischt und diesen Trägergaskomponenten als Precursor 40 sccm HMDSO zugemischt.

Aufgrund ihrer hohen thermischen Stabilität ist die erfindungsgemäß abgeschiedene Vorbeschichtung auch nach dem Schmelztauchbeschichten noch auf der dann vom Schutzüberzug freien Fläche des Stahlprodukts vorhanden. Abhängig vom jeweiligen Verwendungszweck des Stahlprodukts kann die Vorbeschichtung auf der nicht mit dem metallischen Überzug versehenen Fläche verbleiben. Sie wirkt dort ebenfalls korrosionshemmend und bildet im Fall, dass die mit der erfindungsgemäßen Vorbeschichtung versehene Fläche lackiert oder in anderer Weise organisch beschichtet werden soll, zudem einen Haftgrund, durch den die Haftung der jeweiligen Beschichtung auf dem Stahlsubstrat verbessert wird.

Soll die Vorbeschichtung dagegen nach dem Schmelztauchbeschichten von der dann unbeschichtet gebliebenen Fläche des Stahlprodukts entfernt werden, können dazu die bekannten mechanischen Verfahren, wie beispielsweise ein Bürsten, oder chemischen Verfahren, wie beispielsweise eine nach Art eines konventionellen Beizens durchgeführte Behandlung mit Flusssäure, genutzt werden.

Mit den erfindungsgemäßen Verfahren gelingt es betriebssicher, bei minimierter Schichtdicke der Vorbeschichtung eine Benetzung der vom Schutzüberzug freizuhaltenden Fläche mit der Schmelze des Schmelzenbades während des Schmelztauchbeschichtens zu unterbinden. Überraschend hat sich hier gezeigt, dass die erfindungsgemäß aus der Gasphase auf dem Stahlsubstrat abgeschiedene Vorbeschichtung trotz ihrer geringen Schichtdicke so dicht ist, dass ein Anhaften von Schmelze an der freizuhaltenden Fläche sicher verhindert wird. Dies ist selbst dann noch gewährleistet, wenn die Dicke der Vorbeschichtung auf 200 nm, insbesondere 100 nm, beschränkt ist, wobei sich Schichtdicken von mindestens 2 nm, insbesondere von mindestens 10 nm, in der Praxis als besonders effektiv erwiesen haben.

Die erfindungsgemäß beschaffene und auf der vom metallischen Schutzüberzug freizuhaltenden Fläche des jeweiligen Stahlprodukts aus der Gasphase abgeschiedene Vorbeschichtung erweist sich als so temperaturstabil, dass das mit ihr vorbeschichtete Stahlprodukt problemlos die üblicherweise zur Vorbereitung einer Schmelztauchbeschichtung vorgesehenen Wärmebehandlungsschritte durchlaufen kann.

So kann das Stahlprodukt nach dem Auftrag der Vorbeschichtung und bevor es das Schmelztauchbad passiert, bei einer Glühtemperatur von 700 - 900 °C unter einer Glühatmosphäre, die 0,5 - 10 Vol.-% H₂, insbesondere 1 - 5 Vol.-% H₂, und als Rest Stickstoff sowie unvermeidbare Verunreinigungen enthält und deren Taupunkt -50 °C bis -10 °C, insbesondere -45 °C bis - 5 °C, beträgt, für eine Glühdauer von 6 - 300 s im Durchlauf geglüht werden. Die Aufheizrate, mit der das Stahlprodukt jeweils auf die Glühtemperatur erwärmt wird, liegt hier typischerweise bei 0,5 - 35 K/s.

Um die Beschaffenheit der mit dem Überzug zu versehenen Fläche im Hinblick auf gute Haftung des im anschließenden Schmelztauchschritt aufgebrachten Überzugs am Stahlsubstrat weiter zu optimieren, kann das jeweilige Stahlprodukt nach dem Glühen und vor dem Auftrag des Schmelztauchüberzugs einer Überalterungsbehandlung unterzogen werden, bei der es über eine Dauer von 6 - 180 s im Temperaturbereich von 400 - 520 °C gehalten wird.

Für den Eintritt in das Schmelzenbad kann das Stahlprodukt schließlich auf eine Badeintrittstemperatur gebracht werden, die in einem Bereich liegt, dessen Untergrenze die Temperatur des Schmelzenbads -30 °C und dessen Obergrenze die Temperatur des Schmelzenbads +30 °C ist.

Typische Schichtdicken eines durch Schmelztauchbeschichten auf dem jeweiligen Stahlsubstrat erzeugten Schutzüberzugs liegen bei 7,5 µm ± 3,5 µm.

Das erfindungsgemäße Verfahren eignet sich insbesondere zur Verarbeitung von Stahlflachprodukten, die im kontinuierlichen Durchlauf schmelztauchbeschichtet werden. Unter den Begriff "Stahlflachprodukt" fallen alle Walzprodukte, deren Länge sehr viel größer ist als ihre Dicke. Hierzu zählen, wie erwähnt, Stahlbänder und -bleche sowie daraus gewonnene Zuschnitte und Platinen. Ein besonderer Vorteil der Erfindung besteht dabei darin, dass das Stahlflachprodukt als Warmband oder, nach einem Kaltwalzen, im walzharten Zustand dem erfindungsgemäßen Verfahren unterzogen werden kann.

Insbesondere können die erfindungsgemäß mit einem metallischen Schutzüberzug zu versehenden Stahlprodukte aus Feinblechen bestehen. Hierunter werden Stahlbänder oder Stahlbleche mit einer Stärke von kleiner 3 mm verstanden, die im kalt- oder warmgewalzten Zustand zu einem Bauteil kaltumgeformt werden können. Eine Übersicht über typischerweise als Feinbleche für die Kaltumformung vorgesehene Stahlflachprodukte der in Rede stehenden Art gibt die DIN EN 10130. Im Speziellen lassen sich die für das Stahlsubstrat erfindungsgemäß verarbeiteter Stahlprodukte geeigneten Stähle unter eine Legierungsvorschrift zusammenfassen, gemäß der die betreffenden Stähle aus (in Gew.-%) bis zu 16 % Mn, bis zu 3 % Al, bis zu 2 % Si, bis zu 0,3 C, bis zu 0,5 % Ti, bis zu 1 % Ni, bis zu 0,5 % Nb und bis zu 2 % Cr und als Rest aus Eisen und unvermeidbaren Verunreinigungen bestehen. Der Erfolg stellt sich speziell dann ein, wenn das Stahlprodukt zum Schutz vor Korrosion durch Schmelztauchbeschichten mit einer Schutzbeschichtung aus Zink oder einer Zinklegierung beschichtet werden soll. Typischerweise enthalten solche Zn-Beschichtungen bis zu 5 Gew.-% Al, bis zu 2,0 Gew.-% Mg, bis zu 0,2 Gew.-% Fe und in Summe bis zu 10 Gew.-% sonstige Bestandteile, wie Mn und Si, die der Zn-Beschichtung in bekannter Weise zur Einstellung ihrer Eigenschaften zugegeben werden können, und als Rest Zink und herstellungsbedingt unvermeidbare Verunreinigungen.

Typische Schichtdicken der erfindungsgemäß aufgetragenen metallischen Schutzüberzüge liegen im Bereich von 3 - 30 µm.

Wenn hier Gehaltsangaben von Metalllegierungen angegeben sind, so sind diese jeweils auf das Gewicht bezogen, soweit nicht ausdrücklich etwas anderes angegeben ist. Hier gegebenenfalls gemachte Angaben zur Zusammensetzung einer Atmosphäre beziehen sich jeweils auf das Volumen der Atmosphäre, soweit nicht ausdrücklich etwas anderes angegeben ist.

Nachfolgend wird die Erfindung anhand von Ausführungsbeispielen näher erläutert.

Es sind acht Stahlband-Proben P1 - P8 bereitgestellt worden, die aus Stählen mit den in Tabelle 3 angegebenen Zusammensetzungen bestanden.

Die Proben P1 - P8 sollten jeweils an der Oberfläche ihrer einen Seite mit einem Zn-Schutzüberzug versehen werden. Die Oberfläche an der zur mit dem Schutzüberzug zu versehenden Oberfläche gegenüberliegenden anderen Seite der Proben sollte dagegen frei von dem metallischen Schutzüberzug bleiben.

Auf die von dem Überzug freizuhaltende Oberfläche der Proben P1 - P4 ist durch Flammenpyrolyse bei atmosphärischem Druck eine SiO₂-Vorbeschichtung abgeschieden worden. Dazu ist in einer Flammenpyrolyse-Vorrichtung in einem Silan-Verdampfer bei einer Verdampfungstemperatur von 40 °C als siliziumorganischer Precursor jeweils Hexamethyldisiloxan ("HMDSO") verdampft worden. Das verdampfte HMDSO ist mit einem Volumenstrom von 550 ml/min in die von einem Brenner durch Verbrennung eines aus Propan und Luft im Volumenverhältnis 1:10 gebildeten Gasgemischs ausgebrachte, 5 cm breite Brennerflamme eingebracht, durch die Verbrennungshitze pyrolytisch zersetzt und auf der mit einer Fördergeschwindigkeit von 30 m/min unter der Brennerfläche geführten, mit der SiO₂-Vorbeschichtung zu versehenden Oberfläche der Proben P1 - P4 abgeschieden worden.

Die Anzahl Z der von den Proben P1 - P4 absolvierten Durchläufe durch die Flammenpyrolyse-Vorrichtung, die dadurch jeweils erzielte Schichtdicke SD der SiO₂-Vorbeschichtung und das jeweils erreichte Auflagengewicht AG der SiO₂-Vorbeschichtung sind in Tabelle 1 angegeben.

Bei den Proben P5 - P8 ist dagegen auf die von dem Überzug freizuhaltende Oberfläche in einer PE-CVD-Vorrichtung eine SiO₂-Vorbeschichtung abgeschieden worden. Dazu ist bei 60 °C verdampftes HMDSO mit einem Volumenstrom von 40 Standardkubikzentimetern pro Minute ("sccm") mit als Trägergas dienendem, ebenfalls mit einem Volumenstrom von 40 sccm zugeführten Argon gemischt und unter Zugabe von Sauerstoff, das mit einem Volumenstrom von 400 sccm zugeführt worden ist, auf der jeweiligen Oberfläche abgeschieden worden. Die elektrische Leistung der PE-CVD-Vorrichtung betrug 0,3 kW bei einer Frequenz von 350 kHz. Es wurde eine maximale Abscheiderate von 4 nm/s erreicht.

Die jeweils eingehaltene Beschichtungszeit TB, die jeweils erzielte Schichtdicke SD der SiO₂-Vorbeschichtung und das jeweils erreichte Auflagengewicht AG der SiO₂-Vorbeschichtung sind in Tabelle 2 angegeben.

Nach dem Abscheiden der Vorbeschichtung haben die Proben P1 - P8 im kontinuierlichen Durchlauf eine Wärmebehandlung durchlaufen, bei der sie zunächst mit einer Aufheizrate von 10 K/s ± 1 K/s auf eine Haltetemperatur von 800 °C ± 10 °C erwärmt worden sind, bei der sie über 60 s ± 1 s gehalten worden sind. Die Glühatmosphäre während der Glühung bestand zu 5 Vol.-% aus H₂ und als Rest aus N₂ sowie technisch unvermeidbaren Verunreinigungen. Der Taupunkt der Glühatmosphäre lag bei -30 °C.

Anschließend sind die Proben P1 - P8 jeweils mit einer Abkühlrate von 7 K/s ± 1 K/s auf eine Überalterungstemperatur von 470 °C ± 10 °C abgekühlt worden, bei der sie für 30 s ± 1 s gehalten worden sind.

Die Überalterungstemperatur entsprach der Badeintrittstemperatur, mit der die Proben P1 - P8 anschließend in ein Zink-Schmelzenbad eingelaufen sind, das neben unvermeidbaren Verunreinigungen keine weiteren Bestandteile enthielt. Die Temperatur des Schmelzenbads betrug 465 °C ± 5 °C.

Die für den Durchlauf durch das Schmelzenbad benötigte Zeit betrug 2 s ± 1 s. Nach Austritt aus dem Schmelzenbad war auf der mit dem Schutzüberzug zu versehenden Oberfläche der Proben jeweils ein Zn-Schutzüberzug vorhanden, dessen Dicke den angestrebten 7 µm ± 3 µm betrug.

Die mit der SiO₂-Vorbeschichtung versehene Oberfläche war dagegen vollständig frei von dem Zn-Überzug. Eine nachträgliche Entfernung von Zn-Anhaftungen war nicht erforderlich.

**Tabelle 1**

| Probe | Z | SD | AG |
|---|---|---|---|
| | | [nm] | [mg/m²] |
| P1 | 1 | 2 | 4 |
| P2 | 8 | 10 | 22 |
| P3 | 16 | 20 | 44 |
| P4 | 32 | 50 | 110 |

**Tabelle 2**

| Probe | TB | SD | AG |
|---|---|---|---|
| | [s] | [nm] | [mg/m²] |
| P5 | 7 | 25 | 55 |
| P6 | 14 | 50 | 110 |
| P7 | 35 | 130 | 285 |
| P8 | 120 | 430 | 942 |

**Tabelle 3**

| Probe | C | Si | Mn | P | Al | Cr | Mo | Ti | Nb |
|---|---|---|---|---|---|---|---|---|---|
| 1 | 0,002 | 0,02 | 0,1 | 0,005 | 0,03 | 0,03 | 0,001 | 0,050 | 0,001 |
| 2 | 0,002 | 0,10 | 0,40 | 0,04 | 0,02 | 0,03 | 0,001 | 0,040 | 0,020 |
| 3 | 0,05 | 0,10 | 1,40 | 0,01 | 0,02 | 0,50 | 0,001 | 0,020 | 0,001 |
| 4 | 0,12 | 0,10 | 1,70 | 0,01 | 1,30 | 0,50 | 0,100 | 0,001 | 0,020 |
| 5 | 0,20 | 0,10 | 1,70 | 0,01 | 1,50 | 0,10 | 0,100 | 0,001 | 0,001 |
| 6 | 0,16 | 1,50 | 1,60 | 0,01 | 0,05 | 0,05 | 0,001 | 0,001 | 0,001 |
| 7 | 0,15 | 0,25 | 1,80 | 0,01 | 0,70 | 0,70 | 0,001 | 0,020 | 0,030 |
| 8 | 0,22 | 1,8 | 15,6 | 0,04 | 2,5 | 0,8 | 0,01 | 0,001 | 0,030 |

| | | | | | | | | | |
|---|---|---|---|---|---|---|---|---|---|
| Angaben in Gew.-%, Rest Fe und unvermeidbare Verunreinigungen | | | | | | | | | |

## Patentansprüche

1. Verfahren zum Aufbringen eines metallischen Schutzüberzugs auf eine Oberfläche eines Stahlprodukts, bei dem mindestens eine andere Oberfläche frei von dem metallischen Schutzüberzug bleiben soll, wobei der Auftrag des metallischen Schutzüberzugs durch Schmelztauchbeschichten in einem Schmelztauchbad erfolgt und vor dem Schmelztauchbeschichten diejenige Oberfläche, die frei von dem metallischen Schutzüberzug bleiben soll, mit einer aus SiO₂ bestehenden Vorbeschichtung versehen wird, die beim Schmelztauchbeschichten ein Anhaften des metallischen Schutzüberzugs an der betreffenden Oberfläche verhindert, **dadurch gekennzeichnet, dass** als Vorbeschichtung eine aus amorphem Siliziumdioxid bestehende Schicht mit einer Schichtdicke von 0,5 - 500 nm aus der Gasphase auf die von dem metallischen Schutzüberzug freizuhaltende Oberfläche des Stahlprodukts abgeschieden wird.

2. Verfahren nach Anspruch 1, **dadurch gekennzeichnet, dass** die Vorbeschichtung durch Flammenpyrolyse abgeschieden wird.

3. Verfahren nach Anspruch 1, **dadurch gekennzeichnet, dass** die Vorbeschichtung mittels eines chemischen oder physikalischen Gasabscheideverfahrens abgeschieden wird.

4. Verfahren nach einem der voranstehenden Ansprüche,
**dadurch gekennzeichnet, dass** die Schichtdicke der Vorbeschichtung höchstens 200 nm beträgt.

5. Verfahren nach Anspruch 4, **dadurch gekennzeichnet, dass** die Schichtdicke der Vorbeschichtung höchstens 100 nm beträgt.

6. Verfahren nach einem der voranstehenden Ansprüche,
**dadurch gekennzeichnet**, das s die Schichtdicke der Vorbeschichtung mindestens 2 nm beträgt.

7. Verfahren nach Anspruch 6, **dadurch gekennzeichnet, dass** die Schichtdicke der Vorbeschichtung mindestens 10 nm beträgt.

8. Verfahren nach einem der voranstehenden Ansprüche,
**dadurch gekennzeichnet, dass** das Stahlprodukt nach dem Auftrag der Vorbeschichtung und bevor es das Schmelztauchbad passiert bei einer Glühtemperatur von 700 - 900 °C unter einer Glühatmosphäre, die 0,5 - 10 Vol.-% H₂ und als Rest Stickstoff sowie unvermeidbare Verunreinigungen enthält und deren Taupunkt -50 °C bis -10 °C beträgt, für eine Glühdauer von 6 - 300 s im Durchlauf geglüht wird.

9. Verfahren nach Anspruch 8, **dadurch gekennzeichnet, dass** das Stahlprodukt nach dem Glühen und vor dem Schmelztauchüberzug einer Überalterungsbehandlung unterzogen wird, bei der es über eine Dauer von 6 - 180 s im Temperaturbereich von 400 - 520 °C gehalten wird.

10. Verfahren nach einem der voranstehenden Ansprüche,
**dadurch gekennzeichnet, dass** das Stahlprodukt für den Eintritt in das Schmelztauchbad auf eine Badeintrittstemperatur gebracht wird, die in einem Bereich liegt, dessen Untergrenze die Temperatur des Schmelzenbads -30 °C und dessen Obergrenze die Temperatur des Schmelzenbads +30 °C ist.

11. Verfahren nach einem der voranstehenden Ansprüche,
**dadurch gekennzeichnet, dass** das Stahlprodukt ein Stahlflachprodukt ist, dessen Stahlsubstrat durch ein Feinblech gebildet ist.

12. Verfahren nach Anspruch 11, **dadurch gekennzeichnet, dass** das Stahlflachprodukt im walzharten Zustand oder als Warmband für das Schmelztauchbeschichten bereitgestellt wird.

13. Verfahren nach einem der voranstehenden Ansprüche,
**dadurch gekennzeichnet, dass** seine Arbeitsschritte im kontinuierlichen Durchlauf absolviert werden.

14. Verfahren nach einem der voranstehenden Ansprüche,
**dadurch gekennzeichnet, dass** die Vorbeschichtung nach dem Schmelztauchbeschichten von der unbeschichteten Oberfläche des Stahlprodukts entfernt wird.

15. Verfahren nach einem der voranstehenden Ansprüche,
**dadurch gekennzeichnet, dass** die metallische Schutzbeschichtung aus Zn und unvermeidbaren Verunreinigungen sowie jeweils optional bis zu 5 Gew.-% Al, bis zu 2,0 Gew.-% Mg, bis zu 0,2 Gew.-% Fe und in Summe bis zu 10 Gew.-% an einem oder mehreren Elementen der Gruppe "Mn, Si" besteht.

## Claims

1. Method for applying a metallic protective coating to a surface of a steel product, where at least one other surface is to remain free from the metallic protective coating, the metallic protective coating being applied by hot dip coating in a hot dip coating bath, with that surface that is to remain free from the metallic protective coating being provided, prior to the hot dip coating, with a preliminary coating which consists of SiO₂ and which during hot dip coating prevents the metallic protective coating adhering to the surface in question, **characterized in that** the preliminary coating, deposited from the gas phase to that surface of the steel product that is to be kept free from the metallic protective coating, is a layer which consists of amorphous silicon dioxide and has a layer thickness of 0.5 - 500 nm.

2. Method according to Claim 1, **characterized in that** the preliminary coating is deposited by flame pyrolysis.

3. Method according to Claim 1, **characterized in that** the preliminary coating is deposited by means of a chemical or physical vapor deposition process.

4. Method according to any of the preceding claims, **characterized in that** the layer thickness of the preliminary coating is at most 200 nm.

5. Method according to Claim 4, **characterized in that** the layer thickness of the preliminary coating is at most 100 nm.

6. Method according to any of the preceding claims, **characterized in that** the layer thickness of the preliminary coating is at least 2 nm.

7. Method according to Claim 6, **characterized in that** the layer thickness of the preliminary coating is at least 10 nm.

8. Method according to any of the preceding claims, **characterized in that** the steel product, following application of the preliminary coating and before it passes through the hot dip coating bath, is annealed in a continuous run at an annealing temperature of 700 - 900°C under an annealing atmosphere which contains 0.5 - 10 vol% of H₂ and as the balance nitrogen plus unavoidable impurities and which has a dew point of -50°C to -10°C, for an annealing time of 6 - 300 s.

9. Method according to Claim 8, **characterized in that** the steel product, after the annealing and before the hot dip coating, was subjected to overaging treatment in which it is held for a time of 6 - 180 s in the temperature range of 400 - 520°C.

10. Method according to any of the preceding claims, **characterized in that** the steel product, for entry into the hot dip coating bath, is brought to a bath entry temperature which is within a range whose lower limit is the temperature of the melt bath -30°C and whose upper limit is the temperature of the melt bath +30°C.

11. Method according to any of the preceding claims, **characterized in that** the steel product is a flat steel product whose steel substrate is formed by a thin sheet.

12. Method according to Claim 11, **characterized in that** the flat steel product is provided in the roll-hardened state or as hot strip for hot dip coating.

13. Method according to any of the preceding claims, **characterized in that** its working steps are completed in continuous-run operation.

14. Method according to any of the preceding claims, **characterized in that** the preliminary coating is removed from the uncoated surface of the steel product after hot dip coating.

15. Method according to any of the preceding claims, **characterized in that** the metallic protective coating consists of Zn and unavoidable impurities and also in each case optionally up to 5 wt% of Al, up to 2.0 wt% of Mg, up to 0.2 wt% of Fe, and in total up to 10 wt% of one or more elements from the group consisting of 'Mn and Si'.

## Revendications

1. Procédé d'application d'un revêtement protecteur métallique sur une surface d'un produit en acier, selon lequel au moins une autre surface doit rester exempte du revêtement protecteur métallique, l'application du revêtement protecteur métallique ayant lieu par revêtement par immersion en masse fondue dans un bain d'immersion de masse fondue et, avant le revêtement par immersion en masse fondue, la surface qui doit rester exempte du revêtement protecteur métallique étant munie d'un pré-revêtement constitué de SiO₂, qui empêche pendant le revêtement par immersion en masse fondue une adhésion du revêtement protecteur métallique sur la surface en question, **caractérisé en ce qu'**une couche constituée par du dioxyde de silicium amorphe en une épaisseur de couche de 0,5 à 500 nm est déposée en tant que pré-revêtement à partir de la phase gazeuse sur la surface du produit en acier à maintenir exempte du revêtement protecteur métallique.

2. Procédé selon la revendication 1, **caractérisé en ce que** le pré-revêtement est déposé par pyrolyse à la flamme.

3. Procédé selon la revendication 1, **caractérisé en ce que** le pré-revêtement est déposé par un procédé de dépôt de gaz chimique ou physique.

4. Procédé selon l'une quelconque des revendications précédentes, **caractérisé en ce que** l'épaisseur de couche du pré-revêtement est d'au plus 200 nm.

5. Procédé selon la revendication 4, **caractérisé en ce que** l'épaisseur de couche du pré-revêtement est d'au plus 100 nm.

6. Procédé selon l'une quelconque des revendications précédentes, **caractérisé en ce que** l'épaisseur de couche du pré-revêtement est d'au moins 2 nm.

7. Procédé selon la revendication 6, **caractérisé en ce que** l'épaisseur de couche du pré-revêtement est d'au moins 10 nm.

8. Procédé selon l'une quelconque des revendications précédentes, **caractérisé en ce qu'**après l'application du pré-revêtement et avant son passage dans le bain d'immersion de masse fondue, le produit en acier est recuit en continu à une température de recuit de 700 à 900 °C dans une atmosphère de recuit, qui contient 0,5 à 10 % en volume d'H₂, le reste étant de l'azote et des impuretés inévitables, et dont le point de rosée est de -50 °C à -10 °C, pendant une durée de recuit de 6 à 300 s.

9. Procédé selon la revendication 8, **caractérisé en ce qu'**après le recuit et avant le revêtement par immersion en masse fondue, le produit en acier est soumis à un traitement de vieillissement, pendant lequel il est maintenu pendant une durée de 6 à 180 s dans la plage de température allant de 400 à 520 °C.

10. Procédé selon l'une quelconque des revendications précédentes, **caractérisé en ce que**, pour l'entrée dans le bain d'immersion de masse fondue, le produit en acier est porté à une température d'entrée dans le bain, qui se situe dans une plage dont la limite inférieure est la température du bain de masse fondue - 30 °C et dont la limite supérieure est la température du bain de masse fondue + 30 °C.

11. Procédé selon l'une quelconque des revendications précédentes, **caractérisé en ce que** le produit en acier est un produit plat en acier dont le substrat en acier est formé par une tôle mince.

12. Procédé selon la revendication 11, **caractérisé en ce que** le produit plat en acier est mis à disposition à l'état laminé dur ou sous la forme d'une bande chaude pour le revêtement par immersion en masse fondue.

13. Procédé selon l'une quelconque des revendications précédentes, **caractérisé en ce que** ses étapes sont réalisées en continu.

14. Procédé selon l'une quelconque des revendications précédentes, **caractérisé en ce que** le pré-revêtement est éliminé de la surface non revêtue du produit en acier après le revêtement par immersion en masse fondue.

15. Procédé selon l'une quelconque des revendications précédentes, **caractérisé en ce que** le revêtement protecteur métallique est constitué par Zn et des impuretés inévitables, ainsi qu'éventuellement à chaque fois jusqu'à 5 % en poids d'Al, jusqu'à 2,0 % en poids de Mg, jusqu'à 0,2 % en poids de Fe et au total jusqu'à 10 % en poids d'un ou de plusieurs éléments du groupe « Mn, Si ».
